Europäisches Patentamt

European Patent Office

Office européen des brevets

(19)

(11) Veröffentlichungsnummer : **0 068 078**
**B1**

(12) EUROPÄISCHE PATENTSCHRIFT

(45) Veröffentlichungstag der Patentschrift :
07.08.85

(21) Anmeldenummer : 82102486.6

(22) Anmeldetag : 25.03.82

(51) Int. Cl.⁴ : **H 04 B 9/00**, G 01 R 29/26,
G 01 M 11/00

(54) Verfahren zur Verbesserung des Signal-Rauschabstandes verrauschter elektrischer Signalverläufe, insbesondere zur Messung des Rückstreusignals von Lichtwellenleitern.

(30) Priorität : 26.06.81 DE 3125140

(43) Veröffentlichungstag der Anmeldung :
05.01.83 Patentblatt 83/01

(45) Bekanntmachung des Hinweises auf die Patenterteilung : 07.08.85 Patentblatt 85/32

(84) Benannte Vertragsstaaten :
FR GB IT SE

(56) Entgegenhaltungen :
FREQUENZ, Band 32, Nr. 12, Dezember 1978, Seiten 350-356, D. RITTICH et al.: "Messgeräte für die optische Nachrichtentechnik"
RADIO FERNSEHEN ELEKTRONIK, Band 28, Nr. 7, Juli 1979, Seiten 415-418, Berlin, DD. W. BECKER: "Signal-Mittelwertbildung nach dem Boxcarverfahren"

(73) Patentinhaber : Philips Kommunikations Industrie AG
Thurn-und-Taxis-Strasse 10
D-8500 Nürnberg 10 (DE)

(72) Erfinder : Neumann, Ernst-Georg, Prof.Dr.
Zillertaler Strasse 37
D-5600 Wuppertal 12 (DE)
Erfinder : Heckmann, Siegfried, Dipl.-Ing.
Teutonenstrasse 47
D-5600 Wuppertal 1 (DE)

(74) Vertreter : Patentanwälte Dr. Solf & Zapf
Schlossbleiche 20 Postfach 13 01 13
D-5600 Wuppertal 1 (DE)

## Beschreibung

Die vorliegende Erfindung betrifft ein Verfahren zur Verbesserung des Signal-Rauschabstandes verrauschter elektrischer Signalverläufe, insbesondere zur Messung des Rückstreusignals von Lichtwellenleitern, wobei das Rückstreusignal als zumindest teilweiser Verlaufsabschnitt des gesamten Rückstreusignalverlaufs entsprechend dem gewünschten Auflösungsgrad gemittelt und anschließend zeitexpandiert ausgegeben wird.

Ein derartiges Verfahren ist bereits bei einer digitalen Verarbeitung des Rückstreusignals bekannt. Hierbei wird die Rückstreusignalkurve, d. h. der Rückstreusignalverlauf, mit einem schnellen digitalen Transientenrekorder aufgezeichnet, und dann werden die einzelnen Rückstreukurven mit Hilfe eines digitalen Rechners aus N parallelen Addierern und Speichern addiert und gespeichert, wodurch eine Mittlung und somit eine Rauschbefreiung erfolgt. Die digitale Verarbeitung ermöglicht eine sehr effektive Rauschunterdrückung. Für eine Verbesserung des Signalrauschabstandes um den Faktor M werden nur $M^2$ Kurvenverläufe zur Summation benötigt. Der Nachteil dieses Verfahrens ist in den Kosten für den schnellen, aber hochauflösenden digitalen Transientenrekorder und in der aufwendigen Weiterverarbeitung über N parallele Addierer zu sehen.

Es ist bereits auch eine analoge Verarbeitung des Rückstreusignals bekannt. Hierbei wird jeweils nur ein Punkt der Rückstreukurve, d. h. des Rückstreusignalverlaufs, die aus N-Punkten bestehen soll, genutzt. Soll der Signal-Rauschabstand um den Faktor M verbessert werden, so sind $M^2$. N Wiederholungen des Rückstreusignals erforderlich. Rückstreugeräte nach diesem Konzept haben den Nachteil, daß der Signal-Rauschabstand erst nach längerer Mittlungszeit effektiv verbessert wird. Dieser Mittlungszeit sind aber aufgrund von Drift-Effekten bzw. praktischen Anforderungen Grenzen gesetzt. Mit der herkömmlichen analogen Verarbeitung lassen sich also nur relativ kurze Lichtleitfasern bezüglicher ihrer lokalen Dämpfung vermessen.

Aus der Zeitschrift « Frequenz », Band 32, Nr. 12, Dezember 1978, Seiten 350-356 ist ein Verfahren zur Verbesserung des Signal-Rauschabstands zur Messung des Rückstreusignals von Lichtwellenleitern bekannt. Zur Detektierung des im Rauschen liegenden Rückstreusignals wird ein Integrator verwendet, der das Signal-Rauschverhältnis mit Hilfe einer arithmetischen Mittelwertbildung über N Messungen an einer Stelle des Lichtwellenleiters verbessert. Hierzu wird das Rückstreusignal mit einer Sample-and-Hold-Schaltung abgetastet, wobei durch mehrmaliges Erfassen jedes Kurvenpunktes eine Signalmittlung in einem RC-Glied erfolgt, wodurch die oben beschriebene Signal-Rauschabstandsverbesserung erreicht wird.

Der vorliegenden Erfindung liegt die Aufgabe zugrunde, ein Verfahren und eine Schaltung zu schaffen, wobei auf analoger Basis mit relativ geringem Schaltungsaufwand und somit geringen Kosten eine M-fache Verbesserung des Signal-Rauschabstandes mit nur $M^2$ Messungen erzielbar ist. Erfindungsgemäß wird dies dadurch erreicht, daß als Mittlungselement und als Zeitexpander eine Analog-Speicherkette mit einer der gewünschten Auflösung entsprechenden Anzahl von nacheinander angesteuerten kapazitiven Speichern verwendet wird und daß zur Mittlung die Analog-Speicherkette mit einem Summensignal aus dem im Meßzeitraum jeweils vorhandenen Rückstreusignal und ihrem jeweiligen Speicherinhalt beaufschlagt und der das Summensignal teilweise bildende Speicherinhalt destruktiv (löschend) ausgelesen wird. Dabei wird unter Auflösung die Anzahl N der Meßpunkte des Rückstreusignals verstanden, bei denen jeweils eine Messung stattfindet.

Derartige Analog-Speicherketten sind an sich bekannt, jedoch werden sie bisher nur als Zeitexpander verwertet, wobei ein einzelner gewisser Signalverlauf (Signalkurve) gespeichert und zeitverzögert ausgegeben wird. Erfindungsgemäß wird aber nicht nur ein einzelner Signalverlauf gespeichert, sondern ein Summensignal entsprechend $M^2$ Signalverläufen, d. h. beispielsweise bei der Messung des Rückstreusignals von Lichtwellenleitern $M^2$ Rückstreusignalverläufe bei einer gewünschten Verbesserung des Signal-Rauschabstandes um den Faktor M.

Vorteilhafterweise erfolgt die Bildung des Summensignals derart, daß die beiden Signalverläufe zeitrichtig addiert werden. Nach dem Abschluß der Mittlung, wobei die Anzahl der Mittlungen durch den Eingangs-Spannungsdynamikbereich und die maximale Speicherzeit festgelegt wird, wird das in der Analog-Speicherkette anstehende Summensignal zeitexpandiert zur Anzeige oder Weiterverarbeitung ausgelesen. Hierbei kann das verbesserte Signal seriell mit wählbarer Taktrate hinter einer Sample-and-Hold-Stufe zur Weiterverarbeitung zur Verfügung stehen. Genügt der bereits erreichte Signal-Rauschabstand, so kann das Signal beispielsweise auf einem Schreiber zur Auswertung dargestellt werden. Ist der Signal-Rauschabstand noch nicht ausreichend, so ist eine Verarbeitung in Form weiterer digitaler Mittlung vorstellbar. Dabei genügt hier eine langsame und damit kostengünstige digitale Elektronik, beispielsweise aus Analog-Digital-Wandler, Addierer, Speicher, zur weiteren Verarbeitung.

Nach einer Weiterbildung der Erfindung kann es ebenfalls vorteilhaft sein, jeweils nur einen Ausschnitt bestimmter Zeitdauer des Rückstreusignalverlaufs zur Summation einzulesen. Hierdurch kann dann beispielsweise bei der Rückstreumessung von Lichtwellenleitern ein bestimmter Abschnitt der gesamten Lichtwellenleitung in bezug auf seine Dämpfung ausgemessen werden.

In den Unteransprüchen 6 bis 12 sind Weiterbildungen der Erfindung gekennzeichnet.

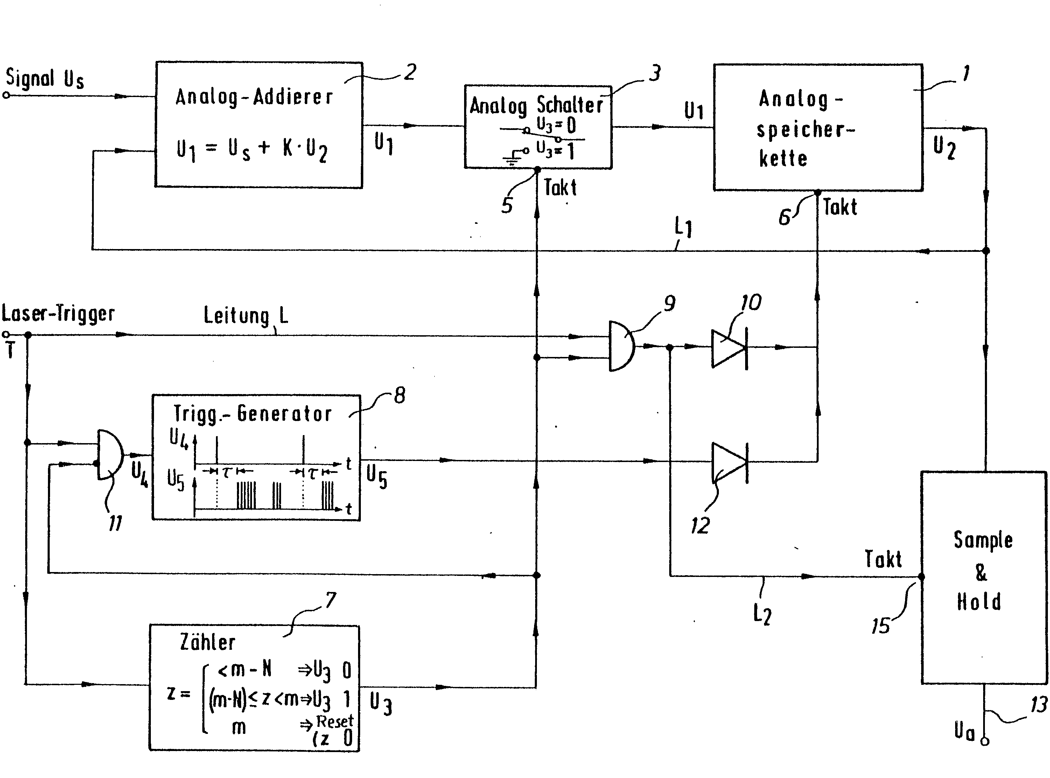

Anhand des in der beiliegenden Zeichnung dargestellten Schaltungsbeispiels wird nun die Erfindung näher erläutert.

Eine erfindungsgemäße Schaltung zur Verbesserung des Signal-Rauschabstandes verrauschter elektrischer Signalverläufe, insbesondere zur Messung des Rückstreusignals von Lichtwellenleitern, besteht aus einer Analog-Speicherkette 1, an deren Eingang ein Analog-Addierer 2, der durch einen entsprechend geschalteten Operationsverstärker realisierbar ist, über einen Analog-Schalter 3, der aus einem oder mehreren Feldeffekt-Transistoren aufbaubar ist, angeschlossen ist. Die erfindungsgemäß verwendete Analog-Speicherkette besteht aus einer der gewünschten Auflösung entsprechenden Anzahl von nacheinander angesteuerten kapazitiven Speichern. Bekannte Analog-Speicherketten sind die sogenannten Charge-Transfer-Devices (CTD) oder die sogenannten Single-Transfer-Devices (STD). Auf den Eingang der Analog-Speicherkette wird die Spannung $U_1$ über den Analog-Schalter 3 angelegt. Am Ausgang der Analog-Speicherkette 1 steht die Spannung $U_2$ an. Diese Spannung $U_2$ wird über eine Rückführungsleitung $L_1$ an den Eingang des Analog-Addierers 2 angelegt. Gleichzeitig steht an dem anderen Eingang des Analog-Addierers 2 eine Spannung $U_s$ an, die dem gemessenen Rückstreusignalverlauf des Rückstreusignals eines Lichtwellenleiters entspricht. Hierbei kann es sich jedoch auch um jeden anderen beliebigen verrauschten Signalverlauf handeln. In dem Analog-Addierer 2 werden die Ausgangsspannung $U_2$ der Analog-Speicherkette und die Eingangsspannung $U_s$ zeitrichtig addiert, so daß sich die Ausgangsspannung $U_1$ aus der Summe dieser beiden Spannungen wie folgt ergibt :

$$U_1 = U_s + k \cdot U_2.$$

Der Ausgang der Analog-Speicherkette ist weiterhin mit dem Eingang einer Sample & Hold-Schaltung 4, z. B. vom Typ FHM-UH3 der Fa. Datel, USA verbunden. Der Steuereingang 5 des Analogschalters und der Steuereingang 6 der Analog-Speicherkette 1 werden jeweils über einen Zähler 7 und einen Trigger-Generator 8 angesteuert, die ihrerseits am Punkt T mit einem nicht dargestellten Laser-Trigger verbunden sind. Der Generator und der Zähler sind aus mehreren digitalen, integrierten Schalterkreisen, z. B. der TTL (Transistor-Transistor-Logik)-Familie realisierbar. Der Laser-Trigger ist von T aus über eine Leitung L, ein UND-Gatter 9 und eine Diode 10 ebenfalls auf den Steuereingang 6 der Analog-Speicherkette 1 geschaltet. Die Verbindung des Laser-Triggers mit dem Trigger-Generator 8 erfolgt über ein UND-Gatter 11, und der Ausgang des Zählers 7 mit der Ausgangsspannung $U_3$ ist

mit einem negierenden Eingang des UND-Gatters 11 an den Trigger-Generator 8 angeschlossen. Die Ausgangsspannung des UND-Gatters 11 ist $U_4$, und die Ausgangsspannung des Trigger-Generators ist $U_5$. Der Trigger-Generator 8 ist über eine Diode 12 mit dem Steuereingang 6 der Analog-Speicherkette 1 verbunden. Die Dioden 10 und 12 dienen zur Entkopplung. Die Sample & Hold-Schaltung 4 weist ebenfalls einen Steuereingang 15 auf, der über eine Leitung $L_2$ mit dem Ausgang des UND-Gatters 9 verbunden ist. Der Ausgang des Zählers 7 ist direkt mit dem Steuereingang 5 des Analog-Schalters 3 verbunden, so daß dort die Spannung $U_3$ ansteht, und weiterhin mit einem Eingang des UND-Gatters 9, an dessen anderem Eingang die Leitung L vom Laser-Trigger über T angeschlossen.

Die Funktionsweise der erfindungsgemäßen Schaltung ist wie folgt. Vor dem Einlesen der ersten Rückstreukurve, d. h. dem ersten Rückstreusignalverlauf, steht der Zähler 7 nach dem Einschalten auf O, d. h. z = O, wobei z die Anzahl der eingelesenen Rückstreukurven darstellt. In diesem Zustand befindet sich kein Signal in der Analog-Speicherkette 1. Damit ist $U_3 = O$, und das UND-Gatter 11 vor dem Trigger-generator 8 ist aktiviert. Wird nun ein nicht dargestellter Laser, dessen Licht in eine nicht dargestellte, zu messende Lichtleitfaser eingestrahlt wird, getriggert, so gelangt dessen Triggerimpuls von T aus über das UND-Gatter 11 auch auf den Trigger-Generator 8. Dieser Trigger-Generator 8 erzeugt N Taktimpulse am Steuereingang 6 (Takteingang) der Analog-Speicherkette 1. Da für $U_3 = O$ der Analogschalter 3 geschlossen ist, werden N-Abtastwerte in die Analog-Speicherkette eingelesen. Hierbei entspricht jeder Abtastwert einem Punkt auf der Rückstreukurve, d. h. dem Rückstreusignalverlauf, der durch die Spannung $U_s$ wiedergegeben wird. Aus diesem Grunde besitzt die Analog-Speicherkette eine der Zahl N entsprechende Anzahl von kapazitiven Speichern. Durch Verzögerung des Laser-Triggers am Eingang des Trigger-Generators 8 läßt sich ein Ausschnitt aus der zu messenden Rückstreukurve ebenfalls einlesen. Es wird demnach ein Zeitfenster aus dem gesamten Rückstreukurvenverlauf ausgewählt, das durch die Veränderung der Verzögerung entlang dem Rückstreukurvenverlauf verschoben werden kann.

Nach dem Einlesen der ersten Rückstreukurve erfolgt nun die Addition von Rückstreukurven im Analog-Addierer 2. Dies erfolgt, wenn ein weiterer Laser-Triggerimpuls bei T ansteht und von dort auf den Trigger-Generator 8 über das UND-Gatter 11 gelangt. Hierdurch werden wieder N Taktimpulse an den Steuereingang 6 der Analog-Speicherkette gelegt. Am Ausgang der Analog-Speicherkette 1 treten nacheinander die Inhalte von N Speicherplätzen auf. Diese Inhalte werden dann über die Rückführungsleitung $L_1$ mit Hilfe des Analog-Addierers 2 zeitrichtig zur vorliegenden Rückstreukurve mit der Spannung $U_s$ addiert und erneut als Spannung $U_1$ entsprechend der Formel $U_1 = U_3 + k \cdot U_2$ addiert

und erneut abgespeichert. Um diese zeitrichtige Addition zu garantieren, ist je nach Organisation des Analogie-Speichers der Analog-Speicherkette 1 ein Verzögerungselement in der Rückführungsleitung $L_1$ erforderlich. Bei weiteren Triggerimpulsen erfolgt eine Wiederteilung des vorbeschriebenen Vorgangs.

Beim Zählerstand z = (m-N) = Anzahl der Meßpunkte auf der Rückstreukurve wird der Eingang des Trigger-Generators 8 abgeschaltet und der Analog-Schalter 3 geöffnet. m bezeichnet den Zählerstand, bei dem der Zähler 7 wieder auf z = O gesetzt wird. Der Mittlungsvorgang ist jetzt abgeschlossen.

Hiernach erfolgt nun ein zeitexpandiertes Auslesen des gemittelten Signals $U_1$. In diesem Fall ist z ⩾ m-N, so daß $U_3$ = 1 ist. Damit ist der Eingang des Trigger-Generators 8 abgeschaltet. Über die Leitung L werden dann die Triggerimpulse des nicht dargestellten Lasers vom Punkt T aus direkt an die Steuereingänge 6, 15 der Analog-Speicherkette 1 und der Sample & Hold-Stufe 4 gelegt. Am Ausgang 13 der Sample & Hold-Stufe 4 liegen die N-Analog-Abtastwerte nach M-facher Verbesserung als $U_a$ an ($M^2$ = m-N-1). Die Rate, mit der die Abtastwerte am Ausgang 13 auftreten, entspricht hier der Lasertaktrate. Es sind jedoch auch andere Ausleseraten möglich, wenn ein entsprechender Taktgenerator an den Eingang T des UND-Gatters 9 gelegt wird. Bei z = m ist in die N Speicherplätze eine O eingelesen. Der Zähler wird wieder auf O gesetzt und damit der Lasertakt auf den Trigger-Generator 8 durchgeschaltet und der Analog-Schalter 3 geschlossen, so daß wiederum das Einlesen der ersten Rückstreukurve beginnen kann.

Die Vorteile des erfindungsgemäßen Verfahrens und der hierzu gehörigen Schaltung liegen in einer effektiven Rauschmittlung, da das gesamte Rückstreusignal genutzt wird, in einem kostengünstigen Verfahren, da ausschließlich analoge Schaltelemente verwendet werden können, in einer einfachen Möglichkeit, einen Ausschnitt des Rückstreusignals darzustellen, und zwar durch Verzögerung des Laser-Triggers vor dem Trigger-Generator und in einer einfachen Bestimmung des Rückstreuortes durch Impulszählung des Sample & Hold-Stufentaktes.

## Patentansprüche

1. Verfahren zur Verbesserung des Signal-Rauschabstandes verrauschter elektrischer Signalverläufe, insbesondere zur Messung des Rückstreusignals von Lichtwellenleitern, wobei das Rückstreusignal als zumindest teilweiser Verlaufabschnitt des gesamten Rückstreusignalverlaufs entsprechend dem gewünschten Auflösungsgrad gemittelt und anschließend zeitexpandiert ausgegeben wird, dadurch gekennzeichnet, daß als Mittlungselement und als Zeitexpander eine Analog-Speicherkette (1) mit einer der gewünschten Auflösung entsprechenden Anzahl von nacheinander angesteuerten kapazitiven Speichern verwendet wird und daß zur Mittlung die Analog-Speicherkette (1) mit einem Summensignal ($U_1$) aus dem im Meßzeitraum jeweils vorhandenen Rückstreusignal ($U_s$) und ihrem jeweiligen Speicherinhalt ($U_2$) beaufschlagt und der das Summensignal teilweise bildende Speicherinhalt destruktiv (löschend) ausgelesen wird.

2. Verfahren nach Anspruch 1, dadurch gekennzeichnet, daß die Abspeicherung des Summensignals ($U_1$) entsprechend der gewünschten Verbesserung erfolgt, und zwar bei einer gewünschten Verbesserung um den Faktor M erfolgt eine $M^2$-fache Summation.

3. Verfahren nach Anspruch 1 oder 2, dadurch gekennzeichnet, daß die beiden das Summensignal ($U_1$) bildenden Signalverläufe ($U_s$ und $U_2$) zeitrichtig addiert werden.

4. Verfahren nach einem oder mehreren der Ansprüche 1 bis 3, dadurch gekennzeichnet, daß nach Abschluß der Mittlung das in der Analog-Speicherkette anstehende Summensignal ($U_2$) zeitexpandiert zur Anzeige oder Weiterverarbeitung ausgelesen wird.

5. Verfahren nach einem oder mehreren der Ansprüche 1 bis 4, dadurch gekennzeichnet, daß jeweils nur ein Ausschnitt bestimmter Zeitdauer des Rückstreusignalverlaufs ($U_s$) zur Summation eingelesen wird.

6. Schaltung zur Verbesserung des Signal-Rauschabstandes verrauschter elektrischer Signalverläufe, insbesondere zur Messung eines durch eine Lichtquelle erzeugten Rückstreusignals von Lichtwellenleitern, insbesondere zur Durchführung des Verfahrens nach den Ansprüchen 1 bis 5, gekennzeichnet durch eine Analog-Speicherkette (1) mit einer der gewünschten Auflösung entsprechenden Anzahl von nacheinander angesteuerten kapazitiven Speichern, an deren Eingang ein Analog-Addierer (2) über einen Analog-Schalter (3) angeschlossen ist und der Ausgang der Speicherkette (1) an einen Eingang des Analog-Addierer (2) über eine Leitung ($L_1$) rückgeführt ist, und an einem weiteren Eingang des Analog-Addierers (2) der Rückstreusignalverlauf als Spannungssignal angelegt ist.

7. Schaltung nach Anspruch 6, dadurch gekennzeichnet, daß der Analog-Schalter (3) und die Analog-Speicherkette (1) jeweils einen Steuereingang (5, 6) aufweisen, die von einem Trigger (T) der das Rückstreusignal erzeugenden Lichtquelle direkt und/oder indirekt über einen Trigger-Generator (8) und/oder Zähler (7) angesteuert sind.

8. Schaltung nach Anspruch 7, dadurch gekennzeichnet, daß der Lichtquellen-Trigger (T) über ein UND-Gatter (9) mit dem Steuereingang (6) der Analog-Speicherkette (1) verbunden ist, und der zweite Eingang des UND-Gatters (9) an den Ausgang des Zählers (7) angeschlossen ist, dessen Eingang mit dem Lichtquellen-Trigger (T) verbunden ist.

9. Schaltung nach einem oder mehreren der Ansprüche 6 bis 8, dadurch gekennzeichnet, daß der Ausgang des Zählers (7) über einen negierten Eingang eines UND-Gatters (11) mit dem Trigger-Generator (8) verbunden ist und der andere Eingang des UND-Gatters (11) an den Lichtquellen-Trigger (T) angeschlossen ist.

10. Schaltung nach einem oder mehreren der Ansprüche 6 bis 9, dadurch gekennzeichnet, daß der Ausgang des Zählers (7) direkt mit dem Steuereingang (5) des Analog-Schalters (3) verbunden ist.

11. Schaltung nach einem oder mehreren der Ansprüche 6 bis 10, dadurch gekennzeichnet, daß der Ausgang der Analog-Speicherkette (1) mit einer Sample & Hold-Schaltung (4) verbunden ist.

12. Schaltung nach Anspruch 11, dadurch gekennzeichnet, daß der Steuereingang (15) der Sample & Hold-Schaltung (4) mit dem Ausgang des UND-Gatters (9) verbunden ist.

## Claims

1. A method of improving the signal-to-noise ratio of noisy electric signal variations, more specifically for measuring the back-scatter signal of optical wave guides, the back-scatter signal being averaged and subsequently time-expanded and thereafter transmitted as an at least partial segment of the variation of the overall back-scatter signal variation in accordance with the desired resolution, characterized in that an analogue storage chain (1) comprising a plurality of consecutively driven capacitive stores in accordance with the desired resolution, is used as an averaging and time-expanding means, and that for this averaging operation the analogue storage chain receives a sum signal $(U_1)$ of the back-scatter signal $(U_s)$ which is always present in the measuring period and its instantaneous memory content $(U_2)$ and the memory content which constitutes the sum signal is read destructively (erasibly).

2. A method as claimed in Claim 1, characterized in that storing the sum signal $(U_1)$ is effected in accordance with the desired improvement, and that for a desired improvement by a factor of M a $M^2$-fold summing operation is effected.

3. A method as claimed in Claim 1 or 2, characterized in that the two signal variations $(U_s$ and $U_2)$ which form the sum signal $(U_1)$ are added together at the appropriate moment.

4. A method as claimed in any one of the Claims 1 to 3, characterized in that after the averaging operation has ended the sum signal $(U_2)$ contained in the analogue storage chain is read in the time-expanded form for indication purposes or for further processing.

5. A method as claimed in any one of the Claims 1 to 4, characterized in that always only a section of the predetermined duration of the back-scatter signal variation $(U_s)$ is entered for the purpose of being summed.

6. A circuit for improving the signal-to-noise ratio of noisy electric signal variations, more specifically for measuring a back-scatter signal of optical wave guides, produced by a light source, particularly for putting into effect the method as claimed in Claims 1 to 5, characterized by an analogue storage chain (1) having a plurality of consecutively driven capacitive stores in accordance with the desired resolution, and to whose input an analogue adder (2) is connected via an analogue switch (3) and the output of the storage chain (1) is fed-back to an input of the analogue adder (2) via a line $(L_1)$, and the back-scatter signal variation is applied as a voltage signal to a further input of the analogue adder (2).

7. A circuit as claimed in Claim 6, characterized in that the analogue switch (3) and the analogue storage chain (1) each have a control input (5, 6) controlled directly and/or indirectly via a trigger generator (8) and/or a counter (7) by a trigger circuit (T) for the light source which produces the back-scatter signal.

8. A circuit as claimed in Claim 7, characterized in that the light source trigger circuit (T) is connected to the control input (6) of the analogue storage chain (1) via an AND-gate (9), and the second input of the AND-gate (9) is connected to the output of the counter (7) whose input is connected to the light source trigger circuit (T).

9. A circuit as claimed in any one of the Claims 6 to 8, characterized in that the output of the counter (7) is connected to the trigger generator (8) via a negative input of an AND-gate (11) and the other input of the AND-gate (11) is connected to the light source trigger circuit (T).

10. A circuit as claimed in any one of the Claims 6 to 9, characterized in that the output of the counter (7) is directly connected to the control input (5) of the analogue switch (3).

11. A circuit as claimed in any one of the Claims 6 to 10, characterized in that the output of the analogue storage chain (1) is connected to a sample-and-hold circuit (2).

12. A circuit as claimed in Claim 11, characterized in that the control input (15) of the sample-and-hold circuit (4) is connected to the output of the AND-gate (9).

## Revendications

1. Procédé pour améliorer le rapport signal-bruit de signaux électriques bruités, notamment pour mesurer le signal rétrodiffusé de guides optiques, selon lequel la valeur moyenne a été prise comme au moins une partie de la variation du signal rétrodiffusé total conformément à la résolution désirée, et ensuite expansée dans le temps, caractérisé en ce que comme élément servant à déterminer la valeur moyenne et comme expanseur de temps est utilisée une chaîne de mémoires analogiques 1 présentant plusieurs mémoires capacitives excitées successivement, dont le nombre correspond à la résolution désirée et que, pour déterminer la valeur moyenne, la chaîne de mémoires analogiques 1, est alimentée par un signal de somme $(U_1)$ provenant du signal rétrodiffusé $(U_s)$ chaque fois présent dans la période de mesure et son contenu de mémoire

respectif ($U_2$) et que le contenu de mémoire constituant en partie le signal de somme est lu de façon destructive.

2. Procédé selon la revendication 1, caractérisé en ce que la mémorisation du signal de somme ($U_1$) s'effectue conformément à l'amélioration désirée, et notamment de façon qu'il se produise une sommation $M_2$ lorsqu'il faut une amélioration requise d'un facteur M.

3. Procédé selon la revendication 1 ou 2, caractérisé en ce que les deux signaux ($U_s$ et $U_2$) constituant le signal de somme ($U_1$) sont additionnés à des intervalles déterminés.

4. Procédé selon l'une ou plusieurs des revendications 1 à 3, caractérisé en ce qu'après la détermination de la valeur moyenne, le signal de somme ($U_2$) présent dans la chaîne de mémoires analogiques est lu d'une façon expansée dans le temps pour l'affichage ou le traitement ultérieur.

5. Procédé selon l'une ou plusieurs des revendications 1 à 4, caractérisé en ce que chaque fois seule une partie d'une durée déterminée de la variation de signal rétrodiffusé ($U_s$) est enregistrée pour la sommation.

6. Circuit pour améliorer le rapport signal-bruit de signaux électriques bruités, notamment pour la mesure d'un signal rétrodiffusé pour la mise en œuvre du procédé selon la revendication 1 à 5, caractérisé par une chaîne de mémoires analogiques (1) présentant plusieurs mémoires capacitives successivement excitées, dont le nombre correspond à la résolution désirée, mémoires à l'entrée desquelles est connecté un additionneur analogique (2) par l'intermédiaire d'un commutateur analogique (3), alors que la sortie de la chaîne de mémoires (1) est ramenée à une entrée de l'additionneur analogique (2) par un conducteur ($L_1$), alors que le signal rétrodiffusé est appliqué comme signal de tension à une autre entrée de l'additionneur analogique (2).

7. Circuit selon la revendication 6, caractérisé en ce que le commutateur analogique (3) et la chaîne de mémoires analogiques (1) présentent chaque fois une entrée de commande (5, 6), entrées qui sont excitées par un enclencheur (T) de la source lumineuse engendrant le signal rétrodiffusé de façon directe et/ou indirecte par l'intermédiaire d'un générateur d'enclenchement (8) et/ou d'un compteur (7).

8. Circuit selon la revendication 7, caractérisé en ce que l'enclencheur de source (lumineuse T) est connecté par l'intermédiaire d'une porte ET (9) à l'entrée de commande (6) de la chaîne de mémoires analogique (1), et que la deuxième entrée de la porte ET (9) est connectée à la sortie du compteur (7), dont l'entrée est connectée à l'enclencheur de sources lumineuses.

9. Circuit selon l'une ou plusieurs des revendications 6 à 8, caractérisé en ce que la sortie du compteur (7) est connectée par l'intermédiaire d'une entrée niée d'une porte ET (11) au générateur d'enclenchement (8) et que l'autre entrée de la porte ET (11) est connectée à l'enclencheur de source lumineuse (T).

10. Circuit selon l'une ou plusieurs des revendications 6 à 9, caractérisé en ce que la sortie du compteur (7) est connectée de façon directe à l'entrée de commande (5) du circuit analogique (3).

11. Circuit selon l'une ou plusieurs des revendications 6 à 10, caractérisé en ce que la sortie de la chaîne de mémoires analogiques (11) est connectée à un circuit de maintien et d'échantillonnage (4).

12. Circuit selon la revendication 11, caractérisé en ce que l'entrée de commande (15) du circuit de maintien et d'échantillonnage (4) est connecté à la sortie de la porte ET (9).

Signal $U_s$

**Analog-Addierer** 2

$$U_1 = U_s + K \cdot U_2$$

$U_1$

**Analog Schalter** 3
$U_3 = 0$
$U_3 = 1$
Takt
5

$U_1$

**Analog-speicher-kette** 1

$U_2$

6 Takt

$L_1$

Laser-Trigger

$\overline{T}$

Leitung L

9   10

**Trigg.-Generator** 8

$U_4$
$\tau$   $\tau$   t
$U_5$
t

$U_5$

11   $U_4$

12

**Zähler** 7

$$z = \begin{cases} < m-N & \Rightarrow U_3 \; 0 \\ (m-N) \le z < m \Rightarrow U_3 \; 1 \\ m & \Rightarrow \text{Reset} \\ & (z \; 0 \end{cases}$$

$U_3$

$L_2$

Takt
15

**Sample & Hold**

13

$U_a$

0 068 078